# FASCICULE DE BREVET EUROPEEN

(11) **EP 0 811 987 B1**
(45) Date de publication et mention de la délivrance du brevet: **03.03.1999**
(21) Numéro de dépôt: 97401014.2
(22) Date de dépôt: 05.05.1997
(51) Int. Cl.: G11C 16/06, H03K 4/00

(54) **Circuit de production d'une haute tension de programmation**
Hochprogrammierspannungsgeneratorschaltung
Circuit to produce high programming voltage

(30) Priorité: 07.05.1996 FR 9605719
(43) Date de publication de la demande: 10.12.1997
(73) Titulaire: STMicroelectronics S.A., 94250 Gentilly (FR)
(72) Inventeur: Lisart, Mathieu, 75116 Paris (FR); Sourgen, Laurent, 75116 Paris (FR)
(74) Mandataire: Schmit, Christian Norbert Marie

(56) Documents cités:
- US-A- 4 628 487
- PROCEEDINGS IEEE CUSTOM INTEGRATED CIRCUITS CONFERENCE, 16 - 19 Mai 1988, NEW YORK, US, pages 4.2.1-4.2.4, XP000043914 CARNEY ET AL: "Configurable EEPROMs for ASICs"

## Description

L'invention a pour objet un circuit de production d'une haute tension de programmation. Elle est plus particulièrement applicable à la programmation des cellules mémoires de type non volatile comportant notamment un transistor à grille flottante comme organe de mémorisation. Néanmoins elle peut être utilisée pour la programmation d'autres cellules mémoires, notamment des mémoires statiques ou dynamiques, dans la mesure où un contrôle de la progression de leur tension de programmation doit être effectué. Avec l'invention on sait maîtriser l'évolution de cette tension de programmation au moment de son établissement. Elle a plus généralement pour but le contrôle de la progression de n'importe quelle tension.

Dans le domaine des mémoires non volatiles, dont les cellules sont de type EPROM, EEPROM ou bien EPROM Flash, il est courant de devoir appliquer des hautes tension de l'ordre d'une vingtaine de Volts pour obtenir le stockage de charges dans la grille flottante d'un transistor à grille flottante. Normalement les circuits d'alimentation externes comportent un circuit d'alimentation pour produire cette haute tension. Cependant quand le circuit intégré pour lequel une haute tension de programmation doit être produite est un circuit embarqué, notamment quand il s'agit d'une puce d'une carte à puce, la haute tension de programmation doit être produite à l'intérieur du circuit intégré. On sait, à partir d'une faible tension d'alimentation générale, par exemple de 5 Volts, produire des hautes tensions internes, par exemple de l'ordre de 20 Volts.

L'évolution des technologies amène cependant à préconiser des alimentations générales de valeurs plus basses par exemple 3 Volts, voire 1,8 Volts. L'intérêt de ces solutions très basse tension est que l'énergie globale dissipée dans un circuit intégré est réduite, sa température est donc plus basse, et il fonctionne d'autant mieux. En outre, avec la miniaturisation des circuits, les tensions de claquage ou de changement d'état sont réduites de sorte que l'alimentation basse tension devient une nécessité. Cependant, malgré cette miniaturisation, le recours à des hautes tensions de programmation est toujours nécessaire.

Le principe de la production d'une haute tension de programmation à l'intérieur d'un circuit intégré consiste à utiliser un circuit élévateur de tension à l'intérieur de ce circuit intégré. Un circuit élévateur de tension est constitué par exemple par un multiplicateur de type SCHENKEL, ou bien par une pompe de charge. La technique de réalisation de ces circuits élévateurs est telle que pour une tension d'alimentation donnée, par exemple 5 Volts, la valeur de la haute tension produite est limitée par un maximum, par exemple 20 Volts. Si la tension d'alimentation est plus faible, par exemple 3 Volts, on peut encore arriver à produire des différences de potentiels de 18 Volts en produisant des tensions positives et des tensions négatives dans le circuit. Cependant, on est alors confronté à un problème de coût lié à cette complexité de circuit. A fortiori si la tension d'alimentation est inférieure à 3 Volts.

En outre, la sortance de l'élévateur de tension, notamment quand c'est une pompe de charge, est d'autant plus faible que la haute tension de programmation produite est élevée par rapport à la tension d'alimentation générale de départ. Compte tenu que les plans mémoires, les lignes de bits, n'ont pas un isolement parfait, il existe des fuites électriques qui, en combinaison avec les contraintes techniques de réalisation de l'élévateur de tension, amènent à retenir des maximums admissibles sur les tensions de programmation. En pratique, on observe actuellement qu'une haute tension de programmation la plus haute possible est limitée par 18 Volts environ pour une tension de 1,8 Volts.

Lorsqu'on veut appliquer une haute tension de programmation sur une cellule mémoire, on ne doit pas appliquer cette haute tension brutalement. On risque, si on le fait, de détériorer une couche d'oxyde de grille placée entre une grille flottante et une région drain ou source du transistor à grille flottante à programmer. Pour éviter ce problème, à partir de la haute tension de programmation on produit une rampe de tension dont la pente, croissante en fonction du temps, est calibrée de manière à rester inférieure à une pente critique. Le circuit qui réalise la rampe de tension comporte un transistor de type N connecté par son drain à une source de haute tension de programmation (constante), et par sa source au lieu d'application de la rampe de tension. Sur la grille de ce transistor N, on applique un signal croissant régulièrement avec le temps de manière à contrôler la tension disponible sur la source. Il apparaît alors que cette tension disponible sur la source suit, à une chute de tension VTN près, la valeur du signal appliqué sur la grille de commande de ce transistor N.

Or La chute de tension réellement occasionnée dans le transistor N est en fait une addition d'une chute de tension intrinsèque du transistor de type N et d'une chute de tension liée à l'écart de tension source du transistor N-substrat du circuit intégré. On retient généralement un écart global de 2 Volts. Ceci amène à ne pouvoir disposer que d'une tension maximale en fin de rampe de 16 Volts. Si on veut une tension supérieure à 16 Volts, il faut augmenter la haute tension de programmation continue au détriment de la sortance de la pompe de charge. De ce fait le problème n'est pas vraiment résolu car quand le circuit débite cette tension chute.

Dans l'article PROCEEDINGS IEEE CUSTOM INTEGRATED CIRCUITS CONFERENCE 16-19 Mai 1988, NEW YORK, US, pages 4.2.1-4.2.4, XP000043914 CARNEY ET AL: "Configurable EEPROMs for ASICs", conforme au préambule de la revendication 1, on a proposé un circuit de production d'une haute tension de programmation comprenant un élévateur et un circuit de commande pour dévier vers la masse une certaine quantité du courant de sortie de l'élévateur de manière à empêcher la tension de sortie d'atteindre sa valeur nominale constante. On génère ainsi une haute tension de programmation en rampe. Néanmoins, l'excès de courant ainsi dévié est consommé au détriment de la sortance du circuit, en ayant également pour conséquence de limiter la valeur maximum de la rampe. Un tel circuit ne permet donc pas de résoudre le problème technique précité.

Dans l'invention on se propose de remédier à ce problème en agissant complètement différemment. En effet, au lieu de contrôler la tension disponible à la source d'un transistor de type N, on va contrôler le débit du courant passant au travers d'un transistor de type P connecté en sortie de l'élévateur de tension. En mettant en série avec ce transistor de type P un condensateur on obtient alors une charge du condensateur, à courant constant, et donc une tension croissant linéairement. Dans un exemple, le condensateur pourra être constitué uniquement par l'ensemble des connections, les lignes de bits ou lignes de mots, du plan mémoire de la mémoire à programmer. La charge à courant constant est obtenue en polarisant le transistor de type P à la limite de la conduction avec un écart calibré. Pour un courant constant cet écart est constant, ce qui fait que le signal à appliquer sur la grille de commande du transistor de type P est, pendant cette charge progressive, lui-même constant. C'est plus simple. Le transistor de type P ne présentant pas de chute de tension de conduction du même type que le transistor de type N, on obtient en fin de compte une tension en rampe qui peut culminer à une valeur supérieure à celle à laquelle pouvait culminer la tension obtenue selon l'état de la technique et ce, en utilisant une même haute tension de programmation (de 18 Volts par exemple).

L'invention à donc pour objet un circuit de production d'une haute tension de programmation défini par l'objet de la partie caractérisante de la revendication 1, ainsi qu'une mémoire non volatile définie par l'objet de la revendication 8.

L'invention sera mieux comprise à la lecture de la description qui suit et à l'examen des figures qui l'accompagnent. Celles-ci ne sont données qu'à titre indicatif et nullement limitatif de l'invention. Les figures montrent:
- Figure 1: un exemple de réalisation d'un circuit selon l'invention;
- Figure 2: des diagrammes temporels de signaux mis en oeuvre dans le circuit de l'invention;
- Figure 3: la partie utile de la courbe caractéristique d'un transistor de type P monté en diode;
- Figure 4: une représentation schématique d'un transistor de type P.

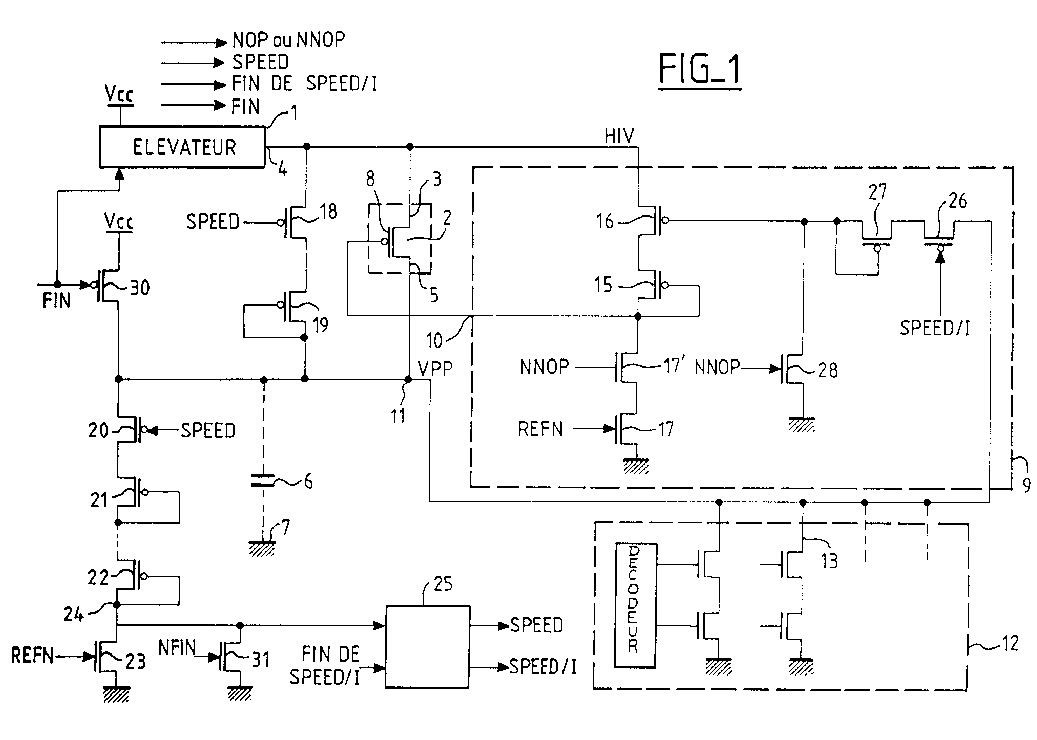

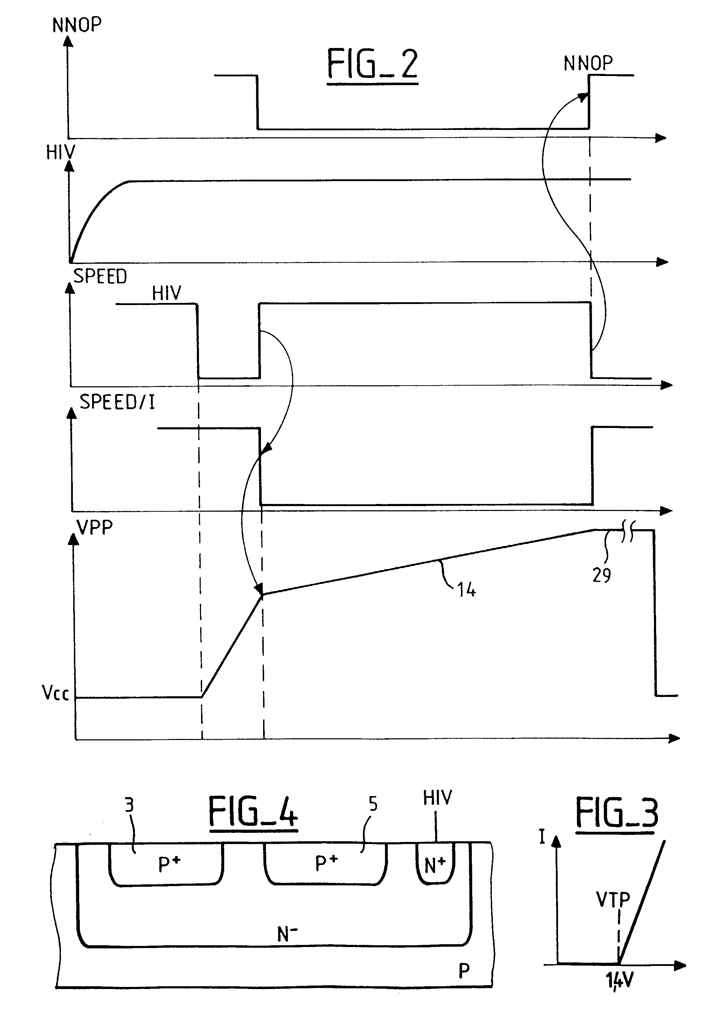

La figure 1 montre un circuit de production d'une haute tension de programmation conforme à l'invention. Ce circuit comporte un circuit élévateur 1 de tension. L'élévateur 1 alimenté par une tension VCC délivre une haute tension continue, HIV. Bien que cela ne soit pas représenté ici le circuit élévateur 1 comporte un circuit de régulation pour que la valeur HIV soit régulée à une valeur choisie à l'avance. Dans un exemple HIV vaut 18 Volts. Le circuit de l'invention comporte également un circuit de commande pour produire à partir de la haute tension continue HIV une haute tension de programmation en rampe VPP. L'allure de cette haute tension de programmation en rampe VPP est visible sur la figure 2. Le circuit de commande de l'invention comporte un premier transistor de charge 2 de type P (il porte un petit rond sur sa grille de commande). Le transistor 2 est relié par sa source 3 à la sortie 4 de l'élévateur 1. Il est relié par son drain 5 à un condensateur 6 à charger. Le condensateur 6 est relié par son autre borne à une masse électrique 7 ou à un autre potentiel de référence. Le transistor 2 est relié par sa grille de commande 8 à un circuit d'ordre 9 faisant partie du circuit de commande.

Le circuit d'ordre 9 est montré ici uniquement pour ses parties utiles à la compréhension de l'effet technique de l'invention. Il comporte bien d'autres fonctionnalités non représentées, correspondant notamment à des validations de bon fonctionnement. Le circuit 9, alimenté par la sortie 4, reçoit certains signaux appelés ici NOP et SPEED/I. Il délivre sur sa sortie 10 un signal à appliquer sur la grille 8 du transistor 2.

Une connexion 11 sur laquelle est disponible la tension VPP est par exemple reliée à un plan mémoire 12 de la mémoire du circuit intégré qui contient le circuit de l'invention. Les connexions de lignes de bits 13 de cette mémoire 12 présentent une capacité et sont équivalentes au condensateur 6. Le condensateur 6 peut donc être omis si le transistor 2 est calculé en conséquence pour que le courant qu'il débite, en chargeant la capité utile du plan mémoire 12, est de nature à provoquer une croissance 14 (figure 2) de la tension VPP conforme aux souhaits.

Le réglage du courant qui passe à travers le transistor 2 est obtenu en imposant sur sa grille une tension sensiblement égale à HIV - VTP - ε. Pour fixer les idées, dans un exemple HIV vaut 18 Volts, VTP vaut 1,4 Volts, et ε est de l'ordre de 0,2 Volts. Avec une telle valeur, on peut obtenir un courant de charge de 10 micro-ampères correspondant à la rampe 14. Un courant ainsi calibré est obtenu simplement, dans un exemple, en reliant un transistor de type P 15 monté en diode en parallèle sur la source et la grille de commande du transistor 2.

La figure 3 montre, en l'exagérant, le décalage et l'allure de la tension VTP obtenus avec une diode de type P quand elle conduit. Dans l'exemple le décalage de base vaut 1,4 Volts. Ce décalage de base est complété par une chute ohmique de conduction dans la diode liée à la résistance de conduction de cette diode. Ceci conduit à une caractéristique inclinée et non pas verticale au delà de VTP. Pour la commande de la conduction du transistor 2, il suffit d'appliquer ce décalage de tension sur la grille de commande 8. Ceci est réalisé simplement dans l'exemple en connectant la diode 15 à la haute tension de programmation HIV, notamment par l'intermédiaire d'un transistor 16 de type P recevant un signal adéquat sur sa grille de commande. Lorsque le transistor 16 est conducteur (il ne provoque aucune chute de tension puisqu'il est de type P), le décalage de tension calibrée est appliqué sur la grille 8. Il suffit donc d'appliquer un échelon de tension sur la grille de commande du transistor 16 pour que celui-ci se mette à conduire. Il n'est pas nécessaire de produire une rampe comme signal de commande. En effet une fois que le transistor 2 conduit, il conduit à courant constant (la valeur de ce courant constant est liée d'une part à la géométrie de ce transistor, d'autre part à la valeur du décalage, et enfin à la valeur de la capacité constituée par le plan mémoire 12 et/ou la capacité 6). Dans ces conditions, la tension VTP suit une rampe 14 comme indiqué ci-dessus.

Dans l'invention on s'est rendu compte qu'une fois que la tension VPP avait atteint sa valeur nominale, la charge à courant constant ne se produisait plus puisque VTP était proche de HIV. Ce n'est pas gênant puisque la tension nominale est atteinte. Cependant, pour la programmation il peut alors être nécessaire de disposer d'un courant supérieur aux 10 micro-ampères par lequel on avait limité la charge. Dans ce but dans l'invention, au moment où la tension nominale est atteinte, on bloque le transistor 16 et on relie le drain du transistor 15 et donc la grille du transistor 2 à la masse par l'intermédiaire de deux transistors 17 et 17' de type N en cascade. Le transistor 17 est commandé par un signal REFN (constant) qui rend passant ce transistor 17 à la limite de la conduction. Ceci signifie que ce transistor 17 est capable de ne laisser passer qu'un petit courant, par exemple entre 1 et 2 micro-ampères. Le transistor 17' reçoit un signal de commande NNOP qui le rend passant après que la tension nominale ait été atteinte (voir figure 2).

Ce courant faible permet de faire chuter la tension sur le drain du transistor 15 bien au-delà de HIV-VTP - ε. Ainsi, lorsque la rampe 14 a atteint son maximum, la tension disponible sur la grille 8 se décharge par les transistors 17 et 17'. Il en résulte que le transistor 2 qui auparavant était mené d'une manière à laisser passer un courant calibré va être maintenant commandé en saturation. Il est alors susceptible de laisser passer un courant de 100 micro-ampères si nécessaire. Dans l'invention, à la fin de la rampe, on augmente donc la valeur du courant qu'est susceptible de débiter le transistor 2.

La pente de la rampe 14 ne doit être maîtrisée qu'à partir du moment où la tension VPP atteint une zone critique correspondant au début d'un effet tunnel dans la programmation des transistors à grilles flottantes. Par exemple cette tension critique est de l'ordre de 10 Volts. Plutôt que de produire une rampe 14 croissant depuis 0 Volts, ou à la rigueur depuis la tension d'alimentation du circuit intégré, VCC, jusqu'à la valeur nominale, on préfère dans l'invention provoquer une croissance rapide de la tension VPP, pendant une première période, avant de maîtriser une croissance 14, plus lente.

Ceci pourrait en théorie être réalisé avec le transistor 2 qui serait seul commandé en conséquence. Dans un premier temps la grille de commande 8 serait portée à zéro puis elle serait portée à une valeur de calibration pendant la durée de la montée 14 avant d'être reportée à zéro quand la tension nominale a été atteinte. Dans un mode de réalisation préféré, on réalise en plus un autre transistor de type P 18. Le transistor 18 est plus gros que le transistor 2. Par exemple sa largeur est 10 fois plus grande. Il peut laisser passer 1O fois plus de courant. Le transistor 18 est connecté en parallèle sur le transistor 2 et est commandé par un signal d'accélération SPEED, voir figure 2. Le signal SPEED, a en temps normal, une valeur HIV. Pendant la charge rapide du condensateur 6 le signal SPEED est porté à un niveau très faible, proche de 0 Volt. Au moment de cette charge rapide le transistor 18 conduit. Pour des raisons pratiques, le transistor 18 est en cascade avec un transistor 19 monté en diode. Le signal SPEED, produit extérieurement au circuit, peut être commuté par une horloge reliée à un séquenceur.

L'impulsion négative du signal SPEED qui fait conduire le transistor 18 met également en service par la commande d'un transistor P 20, une chaîne de transistors P 21 à 22. Les transistors 21 à 22 sont montés en diodes. Ils sont en cascade les uns avec les autres et avec un transistor 23 de type N entre le noeud 11 et la masse. Le transistor 23 est polarisé à la limite de la conduction par un signal REFN. En temps normal, un noeud 24 intermédiaire entre la chaîne de transistors 21 à 22 et le transistor 23 est porté à zéro Volt. Au moment de l'application du signal SPEED, du fait de la montée en tension du noeud 11, il arrive un moment où le transistor 20 et les diodes 21 à 22 se mettent à conduire. Dans ces conditions le transistor 23, à la limite de la conduction, a tendance à rester bloqué de sorte que la tension au noeud 24 monte. En admettant qu'une chute de tension se produit dans chacune des diodes 21 à 22, de l'ordre de 1,4 Volt, en mettant en cascade six diodes dans un exemple, et en admettant que la chute de tension dans le transistor 23 est de l'ordre de 2 Volts, on arrive à un basculement du signal disponible sur le noeud 24 de 0 à 2 Volts lorsque VPP vaut environ 10 Volts. On se sert du signal sur le noeud 24 pour provoquer d'une part le basculement en retour du signal SPEED à sa valeur haute. Autrement dit l'échelon du signal SPEED est produit par une commande externe au circuit intégré, son retour est provoqué par le signal du noeud 24. On sait avec un circuit logique 25, comportant notamment des bascules D, réaliser facilement une telle fonction.

Ce faisant, lorsque le signal SPEED remonte à la valeur HIV on peut d'autre part démarrer la rampe 14. On se sert alors également du signal disponible sur le noeud 24 pour produire dans le circuit 25 un signal impulsionnel SPEED/I, inverse du signal SPEED après la charge rapide qui va provoquer la rampe 14. La figure 2 montre, pour les signaux SPEED, SPEED/I et VPP, les implications chronologiques.

Le circuit 9 comporte, en le simplifiant à ce qui est utile, un transistor de type P 26, en cascade avec un transistor de type P 27 monté en diode. Le transistor 26 alimenté par VPP reçoit le signal SPEED/I sur sa grille de commande. Un transistor 28 de type N est relié entre la grille de commande du transistor 16 et la masse. Il est commandé à la limite de la conduction par un signal NNOP appliqué sur sa grille de commande. Au moment de la charge rapide (de zéro jusqu'à 10 volts), le signal NNOP est tel que le transistor 28 est passant et rend très conducteur le transistor 16. Le noeud 10 est alors tiré à zéro. Au moment du début de la rampe 14, figure 2, le transistor 26 est rendu passant par le signal SPEED/I passant à zéro Volt. Le transistor 28 est bloqué. Dans ces conditions, la grille du transistor 16, reliée à cette cascade de transistor P 26 et 27, est portée à un potentiel dont la valeur est sensiblement VPP - VTP - ε. Elle suit VPP à un VTP près. De ce fait, alors que le signal SPEED remontant à HIV bloque le transistor 18 et le transistor 20, le signal SPEED/I à zéro fait conduire le transistor 16 qui lui même fait conduire le transistor 2 d'une manière calibrée. La pente de la charge du condensateur 6 devient plus faible.

De même qu'on introduit le signal SPEED à partir d'une commande externe, on produit par une temporisation externe la fin du signal SPEED/I. Le signal de fin de SPEED/I est par exemple appliqué sur une entrée de basculement du circuit 25. A ce moment, le signal SPEED/I originellement à zéro Volt remonte à une tension élevée bloquant le transistor 26. Dans ces conditions, la grille de commande du transistor 16 resterait à une tension relativement haute si on ne faisait rien. En connectant cette grille par le transistor de type N 28 très résistif à la masse, on décharge ce noeud de sorte que la grille de commande du transistor 16 reçoit un potentiel décroissant: le transistor 16 devient de plus en plus passant. Dans ces conditions, la tension sur la grille de commande du transistor 2, déchargée par le transistor 17, chute. Le transistor 2 devient de plus en plus passant: il est susceptible de laisser passer 100 micro-ampères nécessaires alors qu'on ne tolérait que 10 micro-ampères au moment de la montée de la tension selon la pente 14.

Après la montée 14, le signal VPP subit donc un plateau 29 dont la durée est imposée par un circuit externe et qui correspond à la durée nécessaire à la programmation des cellules mémoires. En pratique cette durée est de l'ordre de 1 milliseconde. A la fin de cette durée par un signal externe FIN à zéro on invalide l'élévateur 1 et on rend conducteur un transistor de type P 30 relié entre la tension d'alimentation VCC du circuit intégré et le noeud 11. Du fait de la sortance limitée de l'élévateur 1, la tension VPP retombe à VCC. Ceci est par ailleurs obtenu en reliant le noeud 24 à un transistor de type N 31 recevant sur sa grille de commande un signal NFIN complémentaire du signal FIN. Le transistor 31 devenant très conducteur, la branche 20 - 22, 31 décharge le noeud 24 en dessous de 10 Volts. Les ordres REFN, NNOP, Fin de SPEED/I et FIN sont appliqués par un circuit externe. Dans l'invention, le mode de commande de la rampe permet par ailleurs d'appliquer le signal SPEED à un instant aléatoire après celui où le potentiel HIV est stabilisé en sortie de l'élévateur 1.

La figure 4 montre la réalisation d'un transistor de type P dans un caisson de type N- d'un substrat de type P. Compte tenu des tensions mises en jeu, les caissons seront portés par une prise de caisson 32 (zone N+) au potentiel HIV.

## Revendications

1. Circuit de production d'une haute tension de programmation comportant un élévateur de tension (1) dont la sortie délivre une haute tension continue (HIV), et un circuit de commande pour produire, à partir de la haute tension continue (HIV), une haute tension de programmation en rampe (Vₚₚ),
caractérisé en ce qu'il comporte un premier transistor de charge (2) de type P relié par sa source (3) à la sortie de l'élévateur pour recevoir la haute tension continue (HIV) qui est constante, par son drain (5) à un condensateur de charge (6), et par sa grille de commande (8) à un circuit d'ordre (9) du circuit de commande pour recevoir un signal constant tel que le transistor (2) est polarisé à la limite de la conduction avec un écart calibré, la haute tension de programmation (Vₚₚ) étant disponible sur le drain (5).

2. Circuit selon la revendication 1, caractérisé en ce que le circuit de commande comporte un générateur d'impulsion pour appliquer un échelon de tension sur la grille de commande (8) du transistor de charge (2).

3. Circuit selon l'une des revendications 1 à 2, caractérisé en ce que le circuit de commande comporte un transistor (15) de type P monté en diode relié par sa source à la source (3) du transistor de charge (2), et par sa grille de commande et son drain à la grille de commande (8) du transistor de charge (2), afin de charger le condensateur (6) à courant constant.

4. Circuit selon la revendication 3, caractérisé en ce que le transistor (15) monté en diode est relié par son drain à un circuit très résistif, comportant par exemple un transistor (17) de type N en série entre ce drain et un potentiel de référence.

5. Circuit selon l'une des revendications 1 à 4, caractérisé en ce que le circuit de commande comporte un circuit pour appliquer l'échelon de tension à une date aléatoire comprise dans une plage de durée.

6. Circuit selon l'une des revendications 1 à 5, caractérisé en ce que le circuit de commande comporte un autre transistor de charge (18), en parallèle avec le premier (2), plus gros que le premier, pour laisser passer un plus fort courant de charge du condensateur (6) pendant une première durée de production de la haute tension de programmation (Vₚₚ).

7. Circuit selon l'une des revendications 1 à 6, caractérisé en ce que le circuit de commande comporte un circuit (16,26,28) pour saturer le premier transistor de charge (2) après une durée de charge à courant constant.

8. Mémoire non volatile comportant un circuit selon l'une quelconque des revendications 1 à 7, caractérisée en ce qu'elle comporte un plan mémoire (12) et en ce que le condensateur de charge (6) est constitué par les lignes de bits (13) du plan mémoire (12).

## Patentansprüche

1. Schaltkreis zum Erzeugen einer hohen Programmierspannung mit einem Spannungsvervielfacher (1), dessen Ausgang eine hohe Gleichspannung (HIV) ausgibt, und einem Steuerschaltkreis zum Erzeugen einer hohen Programmierspannung in Form einer Rampe (Vₚₚ) aus der hohen Gleichspannung (HIV),
dadurch gekennzeichnet, daß
er einen ersten Ladetransistor (2) vom P-Typ umfaßt, der über seine Source (3) mit dem Ausgang des Vervielfachers verbunden ist, um die hohe Gleichspannung (HIV), die konstant ist, zu empfangen, über seinen Drain (5) mit einem Ladekondensator (6) verbunden ist und über sein Steuergate (8) mit einem Befehlsschaltkreis (9) des Steuerschaltkreises verbunden ist, um ein konstantes Signal zu empfangen, so daß der Transistor (2) bis zur Grenze der Leitfähigkeit mit einer vorgegebenen Abweichung vorgespannt ist, wobei die hohe Programmierspannung (Vₚₚ) an dem Drain (5) verfügbar ist.

2. Schaltkreis nach Anspruch 1, dadurch gekennzeichnet, daß der Steuerschaltkreis einen Impulsgenerator zum Anlegen eine Stufenspannung an das Steuergate (8) des Ladetransistors (2) umfaßt.

3. Schaltkreis nach einem der Ansprüche 1 oder 2, dadurch gekennzeichnet, daß der Steuerschaltkreis einen Transistor (15) vom P-Typ umfaßt, der als Diode geschaltet ist, der über seine Source mit der Source (3) des Ladetransistors (2) verbunden ist und über sein Steuergate und sein Drain mit dem Steuergate (8) des Ladetransistors (2) verbunden ist, um den Kondensator (6) mit konstantem Strom aufzuladen.

4. Schaltkreis nach Anspruch 3, dadurch gekennzeichnet, daß der Transistor (15) als Diode geschaltet ist und über seinen Drain mit einem sehr hochohmigen Schaltkreis verbunden ist, der zum Beispiel einen Transistor (17) vom N-Typ in Reihe zwischen diesem Drain und einem Referenzpotential umfaßt.

5. Schaltkreis nach einem der Ansprüche 1 bis 4, dadurch gekennzeichnet, daß der Steuerschaltkreis einen Schaltkreis zum Anlegen der Stufenspannung zu einem beliebigen zeitpunkt in einem Bereich umfaßt.

6. Schaltkreis nach einem der Ansprüche 1 bis 5, dadurch gekennzeichnet, daß der Steuerschaltkreis einen weiteren Ladetransistor (18) parallel zu dem ersten (2) umfaßt, der größer als der erste ist, damit ein größerer Ladestrom des Kondensators (6) während einer ersten Dauer zum Erzeugen der hohen Programmierspannung (Vₚₚ) fließen kann.

7. Schaltkreis nach einem der Ansprüche 1 bis 6, dadurch gekennzeichnet, daß der Steuerschaltkreis einen Schaltkreis (16, 26, 28) zum Sättigen des ersten Ladetransistors (2) nach einer Ladedauer mit konstantem Strom umfaßt.

8. Nicht-flüchtiger Speicher mit einem Schaltkreis nach einem der Ansprüche 1 bis 7, dadurch gekennzeichnet, daß er eine Speicherebene (12) umfaßt und daß der Ladekondensator (6) aus Bitleitungen (13) der Speicherebene (12) besteht.

## Claims

1. A circuit to produce high programming voltage comprising a voltage step-up device (1), the output of which supplies a continuous high voltage (HIV), and a control circuit to produce, from the continuous high voltage (HIV), a high programming ramp voltage (Vₚₚ),
**characterised in that** it comprises a first P-type charging transistor (2) connected by its source (3) to the output of the step-up device to receive the continuous high voltage (HIV), which is constant, by its drain (5) to a charging capacitor (6), and by its control gate (8) to an order-wire circuit (9) of the control circuit to receive a constant signal such that the transistor (2) is biased at the conduction limit with a calibrated deviation, the high ramp programming voltage (Vₚₚ) being available at the drain (5).

2. A circuit according to Claim 1,
**characterised in that** the control circuit comprises a pulse generator to apply a calibrated power source to the control gate (8) of the charging transistor (2).

3. A circuit according to one of Claims 1 to 2,
**characterised in that** the control circuit comprises a P-type transistor (15) configured as a diode connected by its source to the source (3) of the charging transistor (2) and by its control gate and its drain to the control gate (8) of the charging transistor (2), so as to charge the capacitor (6) at constant current.

4. A circuit according to Claim 3,
**characterised in that** the transistor (15) configured as a diode is connected by its drain to a very resistive circuit, comprising for example an N-type transistor (17) in series between this drain and a reference potential.

5. A circuit according to one of Claims 1 to 4,
**characterised in that** the control circuit comprises a circuit for applying the calibrated voltage at an arbitrary date within a time range.

6. A circuit according to one of Claims 1 to 5,
**characterised in that** the control circuit comprises another charging transistor (18), in parallel with the first (2), larger than the first, to transmit a stronger charging current of the capacitor (6) during a first production period of the high programming voltage (Vₚₚ).

7. A circuit according to one of Claims 1 to 6,
**characterised in that** the control circuit comprises a circuit (16, 26, 28) to saturate the first charging transistor (2) after a charging period at constant current.

8. A non-volatile memory comprising a circuit according to any one of Claims 1 to 7,
**characterised in that** it comprises a memory plane (12) and in that the charging capacitor (6) is formed by the bit lines (13) of the memory plane (12).
